# EUROPEAN PATENT APPLICATION

(11) **EP 4 044 262 A1**
(43) Date of publication of application: **17.08.2022**
(21) Application number: 20876250.0
(22) Date of filing: 31.08.2020
(51) Int. Cl.: H01L 33/06, H01L 33/10, H01L 33/38

(54) **WAVELENGTH DOWN-CONVERSION-BASED µLED LIGHT-EMITTING DEVICE WITHOUT ELECTRICAL CONTACT**

(30) Priority: 16.10.2019 CN 201910982153
(71) Applicant: Fu Zhou University, Fuzhou, Fujian 350108 (CN); Mindu Innovation Lab, Fuzhou, Fujian 350108 (CN)
(72) Inventor: ZHANG, Yongai, Fuzhou, Fujian 350108 (CN); WENG, Xuyang, Fuzhou, Fujian 350108 (CN); GUO, Tailiang, Fuzhou, Fujian 350108 (CN); ZHOU, Xiongtu, Fuzhou, Fujian 350108 (CN); WU, Chaoxing, Fuzhou, Fujian 350108 (CN); LIN, Zhixian, Fuzhou, Fujian 350108 (CN); SUN, Lei, Fuzhou, Fujian 350108 (CN); YAN, Qun, Fuzhou, Fujian 350108 (CN)
(74) Representative: Bayramoglu et al.
(86) International application number: PCT/CN2020/112395
(87) International publication number: WO 2021/073283

(57) **Abstract**

The present invention relates to an electrical contact-free µLED light emitting device based on a wavelength down-conversion. The electrical contact-free µLED light emitting device comprises a µLED crystal grain, wavelength down-conversion light emitting layers, an upper driving electrode and a lower driving electrode, insulators, an optical micro-structure and a control module. The upper driving electrode and the lower driving electrode are free from direct electrical contact with the µLED crystal grains, the control module is electrically connected with the upper driving electrode and the lower driving electrode respectively to provide alternating driving signals to the upper driving electrode and the lower driving electrode so as to form a driving electric field, and the driving electric field controls an electron-hole recombination of the µLED crystal grain and emits a first light source which is converted into a second light source via the wavelength down-conversion light emitting layer. As a driving electrode in the electrical contact-free µLED light emitting device based on the wavelength down-conversion provided by the present invention is free from electrical contact with a p-type semiconductor layer and an n-type semiconductor layer in the µLED crystal grain, there are no complicated manufacturing process of a chip in the µLED light emitting device and bonding and mass transfer processes of the µLED chip and a driving chip, so that the production cycle of the µLED light emitting device is shortened effectively and the manufacturing cost of the µLED light emitting device is reduced effectively.

## Description

### BACKGROUND OF THE INVENTION

### 1. Technical Field

The present invention relates to the field of display of integrated semiconductors, particularly to an electrical contact-free µLED light emitting device based on a wavelength down-conversion.

### 2. Description of Related Art

In the technical field of panel display, µLED display refers to miniaturizing a conventional LED to form a micron order LED array so as to achieve a ultra-high density pixel resolution. Compared with OLED and LCD display, µLED has many advantages, and the most prominent advantages of µLED are low power consumption, high brightness, ultrahigh definition, high color saturation, higher response speed, longer service life, higher working efficiency and the like. In addition, due to characteristics of high density, small size and ultra-high pixel, µLED will become a leader of the third generation display technology mainly featuring high fidelity, interaction and individual display. Therefore, µLED display is a reformed novel display technology and is expected to replace almost all LCDs and OLEDs applied in the field of panel display.

At present, µLED display generally refers to performing epitaxial growth on different substrate surfaces through metal organic chemical vapor deposition (MOCVD) by utilizing different processes to form red light, green light and blue light µLED chips with contacted metal electrodes via multiple complicated processes and then bonding the chips to a driving circuit substrate by way of chip welding, wafer welding or thin film transferring to form display pixels. As epitaxy techniques for the red, green and blue µLED chips are different, it is not conducive to developing a full color µLED display device. In addition, it is further needed to precisely align and bond a cathode electrode and an anode electrode with a driving module in the µLED chip in the technology so as to realize a precise electrical contact. The process takes a lot of time as it is needed to pickup, place and assemble a huge amount of µLED crystal grains with a high precision. In order to solve the above-mentioned problems so as to improve the industrial efficiency of µLED devices, it is an urgent need to design and develop a novel µLED light emitting device.

In conclusion, the prevent invention provides an electrical contact-free µLED light emitting device based on a wavelength down-conversion. According to the µLED device, electron-hole recombination is completed by a nano material of a semiconductor structure to generate radiative transition as well. Different from a driving mode of a conventional µLED, an n-type semiconductor layer and a p-type semiconductor layer of the µLED crystal grain are free of direct electrical contact with an external driving electrode. Furthermore, the light emitting brightness of the electrical contact-free µLED light emitting device provided by the present invention is remarkably dependent on driving voltage and frequency. The control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls an electron-hole recombination of the µLED crystal grain and emits a first light source which is converted into a second light source via the wavelength down-conversion light emitting layer to realize color conversion. Thus, according to the electrical contact-free µLED light emitting device based on the wavelength down-conversion provided by the present invention, there are no complicated manufacturing process of a chip in the µLED light emitting device and bonding and mass transfer processes of the µLED chip and a driving chip, so that the production cycle of the µLED light emitting device is shortened effectively and the manufacturing cost of the µLED light emitting device is reduced effectively, and it is expected to improve the market competitiveness of the µLED greatly.

### BRIEF SUMMARY OF THE INVENTION

The present invention is intended to overcome shortcomings in the prior art and provide an electrical contact-free µLED light emitting device based on a wavelength down-conversion. The driving electrode of the device is free of direct electrical contact with the n-type semiconductor layer and the p-type semiconductor layer of the µLED crystal grain. The control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls the electron-hole recombination of the µLED crystal grain and emits the first light source which is converted into a second light source via the wavelength down-conversion light emitting layer to realize color conversion. According to the electrical contact-free µLED light emitting device based on a wavelength down-conversion provided by the present invention, there are no complicated manufacturing process of a chip in the µLED light emitting device and bonding and mass transfer processes of the µLED chip and a driving chip, so that the production cycle of the µLED light emitting device is shortened effectively and the manufacturing cost of the µLED light emitting device is reduced effectively, and it is expected to improve the market competitiveness of the full color µLED greatly.

In order to achieve the above-mentioned objective, a technical scheme of the present invention is as follows: an electrical contact-free µLED light emitting device based on a wavelength down-conversion, comprising: a µLED crystal grain, wavelength down-conversion light emitting layers, an upper driving electrode and a lower driving electrode, insulators and a control module, wherein the upper driving electrode and the lower driving electrode are respectively disposed on two sides of the µLED crystal grain, and the wavelength down-conversion light emitting layers are disposed between the upper driving electrode and the µLED crystal grain and between the lower driving electrode and the µLED crystal grain; the upper driving electrode and the lower driving electrode are free from direct electrical contact with the µLED crystal grain; the control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls an electron-hole recombination of the µLED crystal grain and emits a first light source that is converted into a second light source via the wavelength down-conversion light emitting layers.

In an embodiment of the present invention, the µLED crystal grain is either a blue light µLED crystal grain or a µLED crystal grain capable of emitting light with a wavelength shorter than that of blue light, a horizontal size of the µLED crystal grain ranges from 1 mn to 1000 µm, a longitudinal size thereof ranges from 1 nm to 1000 µm, and a thickness thereof ranges from 1 nm to 100 µm; the µLED crystal grain is formed by connecting several µLED chips in series along a perpendicular direction or by connecting several µLED chips in parallel along a horizontal direction or by stacking several µLED chips arbitrarily.

In an embodiment of the present invention, the µLED includes a p-type semiconductor material, a light emitting structure and an n-type semiconductor material, the p-type semiconductor material, the light emitting structure and the n-type semiconductor material being stacked along a perpendicular direction to form a semiconductor junction; a thickness of the p-type semiconductor material ranges from 1 nm to 2.0 µm, a thickness of the light emitting structure ranges from 1 nm to 1.0 µm, and a thickness of the n-type semiconductor material ranges from 1 nm to 2.5 µm; and the semiconductor structure includes one of or a combination of more of a single semiconductor junction (p-light emitting structure-n semiconductor junction), a semiconductor pair junction (p-light emitting structure-n-light emitting structure-p or n-light emitting structure-p-light emitting structure-n semiconductor junction) and a semiconductor junction.

In an embodiment of the present invention, the upper driving electrode is disposed on a surface of the upper transparent substrate, the lower driving electrode is disposed on a surface of the lower transparent substrate, the upper driving electrode and the lower driving electrode are parallelly or perpendicularly disposed along a horizontal direction, and there is a certain gap between the upper driving electrode and the lower driving electrode to form an independent space.

In an embodiment of the present invention, at least one of the upper driving electrode and the lower driving electrode is a transparent electrode, and a material of the transparent electrode includes one of or a combination of more of graphene, indium tin oxide, a carbon nano tube, a silver nanowire and a copper nanowire; and a material of the other transparent electrode includes a laminated structure of one or more of gold, silver, aluminum and copper or an alloy of more than any two of gold, silver, aluminum and copper.

In an embodiment of the present invention, the wavelength down-conversion light emitting layer irradiated by the first light source emitted by the µLED crystal grain excites the second light source with a longer wavelength, the second light source being any one of a red pixel point light source, a green pixel point light source and a blue pixel point light source; a material of the wavelength down-conversion light emitting layer is a quantum dot material or a fluorescent powder material or a mixed material of both the quantum dot material and the fluorescent powder material; or the wavelength down-conversion light emitting layer is a quantum dot light emitting layer or a fluorescent powder light emitting layer; and a thickness of the wavelength down-conversion light emitting layer ranges from 1 nm to 10 µm.

In an embodiment of the present invention, the wavelength down-conversion light emitting layers can be disposed on the surfaces of the upper driving electrode and the lower driving electrode or can be disposed on an outer surface of the µLED crystal grain or can be mixed and coated together with the µLED crystal grain, and is disposed in the independent space formed by the upper driving electrode and the lower driving electrode.

In an embodiment of the present invention, the insulators can be disposed on the surfaces of the upper driving electrode and the lower driving electrode or can be disposed on the surfaces of the wavelength down-conversion light emitting layers or can be disposed between the wavelength down-conversion light emitting layer and the upper driving electrode and between the wavelength down-conversion light emitting layer and the lower driving electrode; a material of the insulators is an organic insulating material, an inorganic insulating material or a combination of the organic insulating material and the inorganic insulating material; and a thickness of the insulating material ranges from 1 nm to 10 µm.

In an embodiment of the present invention, the control module can provide an alternating voltage with time-varying amplitude and polarity, a waveform of the alternating voltage comprising a sine wave, a triangular wave, a square wave, a pulse or a composite wave of the sine wave, the triangular wave, the square wave and the pulse, and a frequency of the alternating voltage ranging from 1 Hz to 1000 MHz.

In an embodiment of the present invention, the electrical contact-free µLED light emitting device based on a wavelength down-conversion further includes the optical micro-structure that is composed of a distributed Brag reflecting layer and a convex lens, the optical micro-structure being disposed corresponding to the transparent electrode; the distributed Brag reflecting layer is formed by stacking two thin films with high and low refractive indexes; the first light source emitted by the µLED crystal grain can excite the wavelength down-conversion light emitting layer to emit the rays of the second light source to pass through from the top by controlling the thicknesses of the thin films with high and low refractive indexes of the distributed Brag reflecting layer, and the unabsorbed rays are reflected back to excite the wavelength down-conversion light emitting layer again to enhance the emergent intensity of light, so that the light emitting efficiency of the µLED device is improved; and the convex lens is a transparent convex lens, a length of the convex lens is greater than or equal to a horizontal size of the µLED crystal grain, and a width of the convex lens is greater than or equal to a longitudinal size of the µLED crystal grain.

Compared with the prior art, the present invention has the following beneficial effects:
(1) As a driving electrode in the electrical contact-free µLED light emitting device based on the wavelength down-conversion provided by the present invention is free from electrical contact with a p-type semiconductor layer and an n-type semiconductor layer in the µLED crystal grain, there are no complicated manufacturing process of a chip in the µLED light emitting device and bonding and mass transfer processes of the µLED chip and a driving chip, so that the production cycle of the µLED light emitting device is shortened, and the manufacturing cost of the µLED display is reduced.
(2) The control module provided by the present invention is electrically connected with the upper driving electrode and the lower driving electrode respectively to provide alternating driving signals to the upper driving electrode and the lower driving electrode so as to form a driving electric field between the upper driving electrode and the lower driving electrode to control the electrical contact-free µLED light emitting device, and in the driving mode, the light emitting brightness of the electrical contact-free µLED light emitting device can be regulated and controlled effectively by regulating the driving voltage and the working frequency.
(3) The µLED crystal grain provided by the present invention excites the first light source under the alternating signals and emits the second light source via the wavelength down-conversion light emitting layer so as to realize color conversion, and thus, there is no complicated manufacturing process for the three-primary-color chips; and meanwhile, in combination with the optical micro-structure composed of the distributed Bragg reflecting layer and the convex lens, the color conversion efficiency of the electrical contact-free µLED device is improved effectively, and it is of great significance in development and application of the µLED light emitting device and the full color µLED display.

### BRIEF DESCRIPTION OF THE SEVERAL VIEWS OF THE DRAWINGS

FIG. 1 is a structural schematic diagram of an electrical contact-free µLED light emitting device based on a wavelength down-conversion of a first embodiment of the present invention.
FIG. 2 is a working principle diagram of an electrical contact-free µLED light emitting device based on a wavelength down-conversion of a first embodiment of the present invention.
FIG. 3 is a structural schematic diagram of an electrical contact-free µLED light emitting device based on a wavelength down-conversion of a second embodiment of the present invention.
FIG. 4 is a working principle diagram of an electrical contact-free µLED light emitting device based on a wavelength down-conversion of a second embodiment of the present invention.

In the drawings, 100, 200-transparent substrate; 101-lower driving electrode; 201-upper driving electrode; 102, 202 and 203-insulator; 300-blue light µLED chip; 310-blue light µLED crystal grain; 301-n-type semiconductor layer; 302-p-type semiconductor layer; 303-light emitting structure; 400-quantum dot light emitting layer; 500-optical micro-structure; 501-distributed Bragg reflecting layer; 502-convex lens; 600-control module; 111-first light source; 112-second light source.

### DETAILED DESCRIPTION OF THE INVENTION

Specific description of the technical scheme of the present invention will be made below in combination with the drawings.

In order to make purposes, technical schemes and advantages of the present invention clearer, the present invention is further described in detail below in combination with specific embodiments and related drawings. In the drawings, for the purpose of clarity, thicknesses of the layers and areas are increased. As the schematic diagrams, they are not construed to strictly reflect the proportional relation of geometric dimensions. Reference diagrams herein are schematic diagrams of idealized embodiments of the present invention. The embodiments of the present invention shall not be construed as limitation to specific shapes in the regions shown in the drawings and shall include obtained shapes, for example, deviations caused by manufacturing. In the embodiments, they are represented by rectangles or circles. Representations in the drawings are schematic and shall not be construed as limitation to the scope of the present invention. The size of a fluctuating pattern and a fluctuating period of a barrier in the embodiment are within a certain range and can be designed according to an actual requirement. A numerical value of the fluctuating period in the embodiment is only schematic and shall not be construed as limitation to the scope of the present invention. It is to be noted that the terms used herein are merely to describe specific implementation modes rather than being intended to limit the exemplary implementation modes according to the application. As used herein, unless otherwise specified in the context, the singular form is further intended to include plural form. In addition, it is to be further understood that when the terms "comprise" and/or "include" are used in the description, it indicates that there are features, steps, operations, apparatuses, assemblies and/or their combinations.

The present invention provides an electrical contact-free µLED light emitting device based on a wavelength down-conversion, including: a µLED crystal grain, wavelength down-conversion light emitting layers, an upper driving electrode and a lower driving electrode, insulators, an optical micro-structure and a control module, wherein the upper driving electrode and the lower driving electrode are respectively disposed on two sides of the µLED crystal grain, the upper driving electrode and the µLED crystal grain are provided with the wavelength down-conversion light emitting layers, and the lower driving electrode and the µLED crystal grain are provided with the wavelength down-conversion light emitting layers; the upper driving electrode and the lower driving electrode are free from direct electrical contact with the µLED crystal grain; the control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls an electron-hole recombination of the µLED crystal grain and emits a first light source that is converted into a second light source via the wavelength down-conversion light emitting layers.

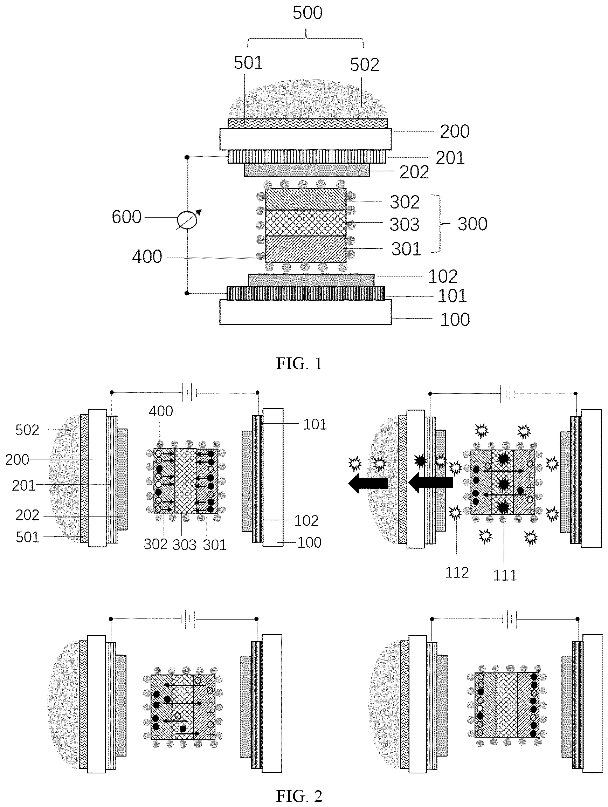

As shown in FIG. 1, the first embodiment of the present invention provides an electrical contact-free µLED light emitting device based on a wavelength down-conversion, including: a µLED crystal grain, wavelength down-conversion light emitting layers, an upper driving electrode and a lower driving electrode, insulators and a control module, wherein the upper driving electrode and the lower driving electrode are respectively located on two sides of the µLED crystal grain, the upper driving electrode and the µLED crystal grain are provided with the wavelength down-conversion light emitting layers, and the lower driving electrode and the µLED crystal grain are provided with the wavelength down-conversion light emitting layers; the upper driving electrode and the lower driving electrode are free from direct electrical contact with the µLED crystal grain; the control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls an electron-hole recombination in a PN junction of the µLED crystal grain and emits the first light source that is converted into the second light source via the wavelength down-conversion light emitting layers.

In the embodiment, the µLED crystal grain is either the blue light µLED crystal grain or the blue light µLED crystal grain capable of emitting wavelengths, such as ultraviolet wavelength, shorter than that of the blue light, the µLED crystal grain is formed by connecting several µLED chips in series along a perpendicular direction or by connecting several µLED chips in parallel along a horizontal direction or by stacking several µLED chips arbitrarily; the µLED chip includes a p-type semiconductor material, a light emitting structure and an n-type semiconductor material, the p-type semiconductor material, the light emitting structure and the n-type semiconductor material being stacked along a perpendicular direction to form a semiconductor junction, namely, the µLED chip; the semiconductor structure can include, but not limited to, a single semiconductor junction (p-light emitting structure-n), a semiconductor pair junction (p-light emitting structure-n-light emitting structure-p junction or n-light emitting structure-p-light emitting structure-n junction) and a plurality of semiconductor junctions and combinations thereof. A thickness of the p-type semiconductor material ranges from 1 nm to 2.0 µm, a thickness of the light emitting structure ranges from 1 nm to 1.0 µm, and a thickness of the n-type semiconductor material ranges from 1 nm to 2.5 µm. A horizontal size of the µLED crystal grain ranges from 1 nm to 1000 µm, a longitudinal size of the µLED crystal grain ranges from 1 nm to 1000 µm, and a thickness thereof ranges from 1 nm to 100 µm. A µLED crystal grain 310 in the embodiment is preferably a single semiconductor junction formed by stacking a p-type semiconductor material 302, a light emitting structure 303 and an n-type semiconductor material 301, namely, a blue light µLED chip 300 (the blue light µLED crystal grain 310 in the embodiment is the blue light µLED chip 300). The thickness of the p-type semiconductor material 302 is 0.8 µm, THE thickness of the light emitting structure 303 is 0.3 µm, and the thickness of the n-type semiconductor material 301 is 1.5 µm. The horizontal size of the blue light µLED crystal grain 310 is 3.0 µm, and the longitudinal size of the blue light µLED crystal grain 310 is 3.0 µm.

In the embodiment, the upper driving electrode 201 is disposed on a surface of the upper transparent substrate 200, the lower driving electrode 101 is disposed on a surface of the lower transparent substrate 100, the upper driving electrode 201 and the lower driving electrode 101 are parallelly or perpendicularly disposed along a horizontal direction, and there is a certain gap between the upper driving electrode 201 and the lower driving electrode 101 to form an independent space; at least one of the upper driving electrode 201 and the lower driving electrode 101 is a transparent electrode, and a material of the transparent electrode can include, but not limited to, graphene, indium tin oxide, a carbon nano tube, a silver nanowire and a copper nanowire and their combinations thereof, and a material of the other transparent electrode can include, but not limited to, gold, silver, aluminum and copper or an alloy or a laminated structure thereof. In the embodiment, the upper driving electrode 201 is preferably a transparent electrode, and a material of the electrode is indium tin oxide.

In the embodiment, the wavelength down-conversion light emitting layer irradiated by the first light source emitted by the µLED crystal grain excites the second light source with a longer wavelength, the second light source being any one of a red pixel point light source, a green pixel point light source and a blue pixel point light source. A material of the wavelength down-conversion light emitting layer is a quantum dot material or a fluorescent powder material or a mixed material of both the quantum dot material and the fluorescent powder material; the wavelength down-conversion light emitting layers can be disposed on the surfaces of the upper driving electrode and the lower driving electrode or can be disposed on an outer surface of the µLED crystal grain or can be mixed and coated together with the µLED crystal grain, and is disposed in the independent space formed by the upper driving electrode and the lower driving electrode; and the wavelength down-conversion light emitting layer can be a quantum dot light emitting layer or a fluorescent powder light emitting layer, and a thickness of the wavelength down-conversion light emitting layer ranges from 1 nm to 10 µm. A 2.5 µm thick green quantum dot light emitting layer 400 is preferably coated to the outer surface of the blue light µLED chip 300 in the embodiment.

In the embodiment, the insulators can be disposed on the surfaces of the upper driving electrode 201 and the lower driving electrode 101 or can be disposed on the surface of the quantum dot light emitting layer 400 or can be disposed between the quantum dot light emitting layer 400 and the upper driving electrode 201 and between the quantum dot light emitting layer 400 and the lower driving electrode 101. The insulating material can be an organic insulating material, an inorganic insulating material and a combination thereof; and a thickness of the insulating material ranges from 1 nm to 10 µm, and the transmittance in visible light is greater than or equal to 80%. In the embodiment, SiO2 insulating layers 202 which are 100 nm thick are preferably deposited on the surfaces of the upper driving electrode 201 and the lower driving electrode 101.

In the embodiment, the control module 600 can provide an alternating voltage with time-varying amplitude and polarity. A waveform of the alternating voltage can be, but not limited to, a sine wave, a triangular wave, a square wave, a pulse or a composite wave thereof. A frequency of the alternating voltage ranges from 1 Hz to 1000 MHz. The square wave with the alternating voltage frequency of 200 KHz is preferably used in the embodiment.

In the embodiment, the optical micro-structure 500 is composed of a distributed Brag reflecting layer 501 and a convex lens 502, the optical micro-structure being disposed corresponding to the transparent electrode. The distributed Brag reflecting layer is formed by stacking two thin films with high and low refractive indexes; the first light source 111 emitted by the µLED chip 300 can excite the wavelength down-conversion light emitting layer 400 to emit the rays of the second light source 112 to pass through from the top by controlling the thicknesses of the thin films with high and low refractive indexes of the distributed Brag reflecting layer, and the unabsorbed rays are reflected back to excite the wavelength down-conversion light emitting layer again to enhance the emergent intensity of light, so that the light emitting efficiency of the µLED device is improved. The convex lens 502 is a transparent convex lens, a length of the convex lens is greater than or equal to a horizontal size of the blue light µLED chip 300, and a width of the convex lens is greater than or equal to a longitudinal size of the blue light µLED chip 300. In the embodiment, the first light source 111 emitted by the blue light µLED chip 300 excites the green quantum dot light emitting layer 400 to emit the rays of the second light source 112 to pass through from the top by preferably adjusting the optical micro-structure 500, and the unabsorbed first light source 111 are reflected back to excite the green quantum dot light emitting layer 400 again to enhance the emergent intensity of light, so that the color conversion efficiency of the electrical contact-free µLED device is improved.

A working principle of an electrical contact-free µLED light emitting device based on a wavelength down-conversion of the embodiment is as follows:

Referring to FIG. 2, within a period T (including T1 and T2), at the moment T1, the upper driving electrode 201 is connected with a cathode and the lower driving electrode 101 is connected with an anode. Under an externally applied electric field action, majority carriers (holes) in the p-type semiconductor 302 drift to the light emitting structure 303 (pn junction), majority carriers (electrons) in the n-type semiconductor 301 drift to the light emitting structure 303 (pn junction), and a part of electrons and holes are recombined in the light emitting structure 303 to emit the first light source 111 so as to excite the second light source 112 excited by the green quantum dot light emitting layer 400 on the surface of the µLED crystal grain 310 (also referred to as the µLED chip 300 in the embodiment) so as to realize color conversion. After the second light source 112 and the first light source 111 pass through the upper insulating layer 102, the upper driving electrode 101 and the upper transparent substrate 100, the second light source 112 is emitted via the distributed Bragg reflecting layer 501 and the convex lens 502, redundant first light source 111 is reflected back by the distributed Bragg reflecting layer 501 to excite the green quantum dot light emitting layer 400 on the surface of the µLED crystal grain 310 gain, and the light emitting efficiency of the µLED crystal grain is improved after multiple feedbacks. Meanwhile, under the externally applied electric field action, electrons and holes that are not recombined respectively drift to the p-type semiconductor layer 302 and the n-type semiconductor layer 301. At the moment T2, the lower driving electrode 101 is connected with the cathode and the upper driving electrode 201 is connected with the anode. Under the externally applied electric field action, minority carriers (electrons) in the p-type semiconductor 302 and electrons in the light emitting structure 303 are pulled back to the n-type semiconductor 301, and minority carriers (holes) in the n-type semiconductor 301 and holes in the light emitting structure 303 are pulled back to the p-type semiconductor 302. Recycling is performed in such a manner for oscillation excitation to enable the µLED device based on wavelength down-conversion to emit light.

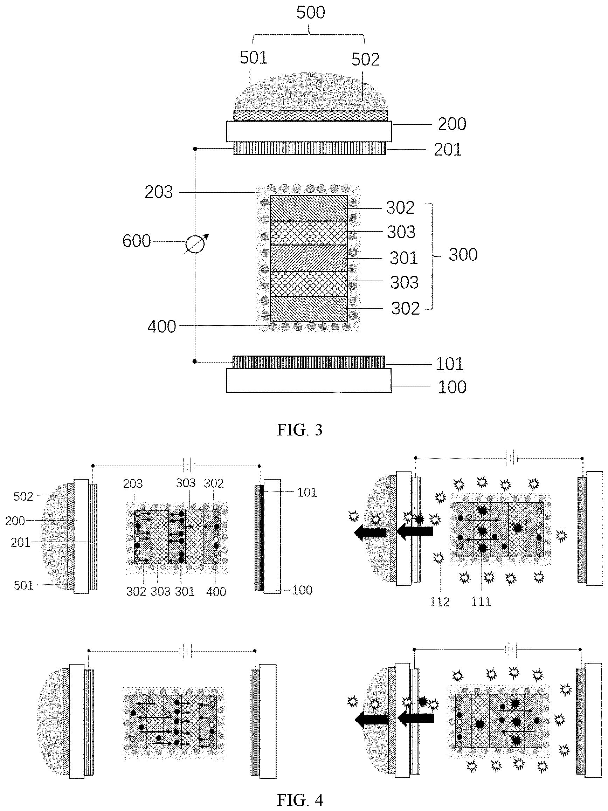

As shown in FIG. 3 and FIG. 4, the second embodiment of the present invention provides an electrical contact-free µLED light emitting device based on a wavelength down-conversion, including: a µLED crystal grain, wavelength down-conversion light emitting layers, an upper driving electrode and a lower driving electrode, insulators and a control module, wherein the upper driving electrode and the lower driving electrode are respectively located on two sides of the µLED crystal grain, the upper driving electrode and the µLED crystal grain are provided with the wavelength down-conversion light emitting layers, and the lower driving electrode and the µLED crystal grain are provided with the wavelength down-conversion light emitting layers; the upper driving electrode and the lower driving electrode are free from direct electrical contact with the µLED crystal grain; the control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls an electron-hole recombination in a PN junction of the µLED crystal grain and emits the first light source that is converted into the second light source via the wavelength down-conversion light emitting layers.

In the embodiment, the µLED crystal grain is either the blue light µLED crystal grain or the blue light µLED crystal grain capable of emitting wavelengths, such as ultraviolet wavelength, shorter than that of the blue light, the µLED crystal grain is formed by connecting several µLED chips in series along a perpendicular direction or by connecting several µLED chips in parallel along a horizontal direction or by stacking several µLED chips arbitrarily; the µLED chip includes a p-type semiconductor material, a light emitting structure and an n-type semiconductor material (the p-type semiconductor material, the light emitting structure and the n-type semiconductor material can be an organic material, an inorganic material or a high molecular material), the p-type semiconductor material, the light emitting structure and the n-type semiconductor material being stacked along a perpendicular direction to form a semiconductor junction, namely, the µLED chip; the semiconductor structure can include, but not limited to, a single semiconductor junction (p-light emitting structure-n), a semiconductor pair junction (p-light emitting structure-n-light emitting structure-p junction or n-light emitting structure-p-light emitting structure-n junction) and a plurality of semiconductor junctions and combinations thereof. A thickness of the p-type semiconductor material ranges from 1 nm to 2.0 µm, a thickness of the light emitting structure ranges from 1 nm to 1.0 µm, and a thickness of the n-type semiconductor material ranges from 1 nm to 2.5 µm. A horizontal size of the µLED crystal grain ranges from 1 nm to 1000 µm, a longitudinal size of the µLED crystal grain ranges from 1 nm to 1000 µm, and a thickness thereof ranges from 1 nm to 100 µm. The µLED crystal grain 310 in the embodiment is preferably a single semiconductor junction formed by stacking the p-type semiconductor material 302, the light emitting structure 303, the n-type semiconductor material 301, the light emitting structure 303 and the p-type semiconductor material 302, namely, the blue light µLED chip 300 (the blue light µLED crystal grain 310 in the embodiment is the blue light µLED chip 300). The thickness of the p-type semiconductor material 302 is 0.3 µm, THE thickness of the light emitting structure 303 is 0.1 µm, and the thickness of the n-type semiconductor material 301 is 0.8 µm. The horizontal size of the blue light µLED crystal grain 310 is 3.0 µm, and the longitudinal size of the blue light µLED crystal grain 310 is 3.0 µm.

In the embodiment, the upper driving electrode 201 is disposed on a surface of the upper transparent substrate 200, the lower driving electrode 101 is disposed on a surface of the lower transparent substrate 100, the upper driving electrode 201 and the lower driving electrode 101 are parallelly or perpendicularly disposed along a horizontal direction, and there is a certain gap between the upper driving electrode 201 and the lower driving electrode 101 to form an independent space; at least one of the upper driving electrode 201 and the lower driving electrode 101 is a transparent electrode, and a material of the transparent electrode can include, but not limited to, graphene, indium tin oxide, a carbon nano tube, a silver nanowire and a copper nanowire and their combinations thereof, and a material of the other transparent electrode can include, but not limited to, gold, silver, aluminum and copper or an alloy or a laminated structure thereof. In the embodiment, the upper driving electrode 201 is preferably a transparent electrode, and a material of the electrode is indium tin oxide.

In the embodiment, the wavelength down-conversion light emitting layer irradiated by the first light source emitted by the µLED crystal grain excites the second light source with a longer wavelength, the second light source is any one of a red pixel point light source, a green pixel point light source and a blue pixel point light source, and the wavelength down-conversion light emitting layer is a quantum dot material or a fluorescent powder material or a mixed material of both the quantum dot material and the fluorescent powder material; the wavelength down-conversion light emitting layers can be disposed on the surfaces of the upper driving electrode and the lower driving electrode or can be disposed on an outer surface of the µLED crystal grain or can be mixed and coated together with the µLED crystal grain, and is disposed in the independent space formed by the upper driving electrode and the lower driving electrode; and the wavelength down-conversion light emitting layer can be a quantum dot light emitting layer or a fluorescent powder light emitting layer, and a thickness of the wavelength down-conversion light emitting layer ranges from 1 nm to 10 µm. The green quantum dot light emitting layer 400 is preferably coated to the outer surface of the blue light µLED chip 300 in the embodiment.

In the embodiment, the insulators can be disposed on the surfaces of the upper driving electrode 201 and the lower driving electrode 101 or can be disposed on the surface of the quantum dot light emitting layer 400 or can be disposed between the quantum dot light emitting layer 400 and the upper driving electrode 201 and between the quantum dot light emitting layer 400 and the lower driving electrode 101. The insulating material can be an organic insulating material, an inorganic insulating material and a combination thereof; and a thickness of the insulating material ranges from 1 nm to 10 µm. The organic insulating material 203 is preferably coated to the surface of the green quantum dot light emitting layer 400 in the embodiment.

In the embodiment, the control module 600 can provide an alternating voltage with time-varying amplitude and polarity. A waveform of the alternating voltage can be, but not limited to, a sine wave, a triangular wave, a square wave, a pulse or a composite wave thereof. A frequency of the alternating voltage ranges from 1 Hz to 1000 MHz. The square wave with the alternating voltage frequency of 200KHz is preferably used in the embodiment.

In the embodiment, the optical micro-structure 500 is composed of a distributed Brag reflecting layer 501 and a convex lens 502, the optical micro-structure being disposed corresponding to the transparent driving electrode. The distributed Brag reflecting layer 501 is formed by stacking two thin films with high and low refractive indexes; the first light source 111 emitted by the µLED chip can excite the wavelength down-conversion light emitting layer to emit the rays of the second light source 112 to pass through from the top by controlling the thicknesses of the thin films with high and low refractive indexes of the distributed Brag reflecting layer, and the unabsorbed rays are reflected back to excite the wavelength down-conversion light emitting layer again to enhance the emergent intensity of light, so that the light emitting efficiency of the µLED device is improved. The convex lens 502 is a transparent convex lens, a length of the convex lens is greater than or equal to a horizontal size of the blue light µLED chip, and a width of the convex lens is greater than or equal to a longitudinal size of the blue light µLED chip. In the embodiment, the first light source 111 emitted by the blue light µLED chip 300 excites the green quantum dot light emitting layer 400 to emit the rays of the second light source 112 to pass through from the top by preferably adjusting the optical micro-structure 500, and the unabsorbed first light source 111 are reflected back to excite the green quantum dot light emitting layer 400 again to enhance the emergent intensity of light, so that the color conversion efficiency of the electrical contact-free µLED device is improved.

The working principle of an electrical contact-free µLED light emitting device based on a wavelength down-conversion of the embodiment is as follows:

Referring to FIG. 3 and FIG. 4, within a period T (including T1 and T2), at the moment T1, the upper driving electrode 201 is connected with a cathode and the lower driving electrode 101 is connected with an anode. Under an externally applied electric field action, majority carriers (holes) of the p-type semiconductor 302 close to the upper driving electrode 201 and majority carriers (electrons) of the n-type semiconductor 301 will drift to the light emitting structure 303 as the blue light µLED crystal grain 310 is the pnp semiconductor junction, namely the blue light µLED chip 300, formed by stacking the p-type semiconductor material 302, the light emitting structure 303, the n-type semiconductor material 301, the light emitting structure 303 and the p-type semiconductor material 302 along the perpendicular direction. Meanwhile, as minority carriers (holes) in the n-type semiconductor 301 and minority carriers (electrons) in the p-type semiconductor 302 close to the lower driving electrode 101 will drift to the light emitting structure 303 at the same time, the electrons and the holes are recombined in the light emitting structure 303 to emit the first light source 111 to excite the green quantum dot light emitting layer 400 on the surface of the blue light µLED chip 300 to emit the second light source 112 so as to realize color conversion. After the second light source 112 and the first light source 111 pass through the upper insulating layer 203, the upper driving electrode 201 and the upper transparent substrate 200, the second light source 112 is emitted via the distributed Bragg reflecting layer 501 and the convex lens 502, redundant first light source 111 is reflected back by the distributed Bragg reflecting layer 501 to excite the green quantum dot light emitting layer 400 on the surface of the µLED crystal grain 310 gain, and the conversion efficiency of the green quantum dot light emitting layer 400 on the surface of the µLED crystal grain 310 is improved after multiple feedbacks. Meanwhile, under the externally applied electric field action, electrons and holes that are not recombined respectively drift to the p-type semiconductor layer 302 and the n-type semiconductor layer 301.

At the moment T2, the lower driving electrode 101 is connected with the cathode and the upper driving electrode 201 is connected with the anode. Under the externally applied electric field action, minority carriers (electrons) in the p-type semiconductor 302 close to the upper driving electrode 201 and electrons in the light emitting structure 303 are pulled back to the n-type semiconductor 301, and minority carriers (holes) in the n-type semiconductor 301 and holes in the light emitting structure 303 are pulled back to the p-type semiconductor 302. A part of electrons and holes will emit blue light 111 after being recombined in the light emitting structure. Meanwhile, majority carriers (holes) in the p-type semiconductor 302 close to the lower driving electrode drift to the light emitting structure 303, majority carriers (electrons) in the n-type semiconductor 301 drift to the light emitting structure 303, and the electrons and holes emit the first light source 111 after being recombined in the light emitting structure 303. Under the externally applied electric field action, electrons and holes that are not recombined respectively drift to the p-type semiconductor layer 302 and the n-type semiconductor layer 301. Under both circumstances, the electrons and holes are recombined to emit the first light source 111 to excite the second light source 112 excited by the green quantum dot light emitting layer 400 on the surface of the µLED chip 300 to realize color conversion. After the second light source 112 and the first light source 111 pass through the upper insulating layer 102, the upper driving electrode 201 and the upper transparent substrate 200, the second light source 112 is emitted via the distributed Bragg reflecting layer 501 and the convex lens 502, redundant first light source 111 is reflected back by the distributed Bragg reflecting layer 501 to excite the green quantum dot light emitting layer 400 on the surface of the µLED chip 300 gain, and the conversion efficiency of the green quantum dot light emitting layer 400 on the surface of crystal grain 310 is improved after multiple feedbacks. Recycling is performed in such a manner for oscillation excitation to enable the µLED device based on wavelength down-conversion to emit light.

The above is the preferred embodiments of the present invention. Changes made based on the technical scheme of the present invention shall fall into the scope of protection of the present invention when generated functions are not beyond the scope of the technical scheme of the present invention.

## Claims

1. An electrical contact-free µLED light emitting device based on a wavelength down-conversion, comprising: µLED crystal grains, wavelength down-conversion light emitting layers, an upper driving electrode and a lower driving electrode, insulators and a control module, wherein the upper driving electrode and the lower driving electrode are respectively disposed on two sides of the µLED crystal grain, and the wavelength down-conversion light emitting layers are disposed between the upper driving electrode and the µLED crystal grain and between the lower driving electrode and the µLED crystal grain; the upper driving electrode and the lower driving electrode are free from direct electrical contact with the µLED crystal grain; the control module is electrically connected with the upper driving electrode and the lower driving electrode respectively to provide alternating driving signals to the upper driving electrode and the lower driving electrode and form a driving electric field between the upper driving electrode and the lower driving electrode, and the driving electric field controls an electron-hole recombination of the µLED crystal grain and emits a first light source that is converted into a second light source via the wavelength down-conversion light emitting layers.

2. The electrical contact-free µLED light emitting device based on a wavelength down-conversion according to claim 1, wherein the µLED crystal grain is either a blue light µLED crystal grain or a µLED crystal grain capable of emitting light with a wavelength shorter than that of blue light, a horizontal size of the µLED crystal grain ranges from 1 mn to 1000 µm, a longitudinal size thereof ranges from 1 nm to 1000 µm, and a thickness thereof ranges from 1 nm to 100 µm; the µLED crystal grain is formed by connecting several µLED chips in series along a perpendicular direction or by connecting several µLED chips in parallel along a horizontal direction or by stacking several µLED chips arbitrarily.

3. The electrical contact-free µLED light emitting device based on a wavelength down-conversion according to claim 2, wherein the µLED comprises a p-type semiconductor material, a light emitting structure and an n-type semiconductor material, the p-type semiconductor material, the light emitting structure and the n-type semiconductor material being stacked along a perpendicular direction to form a semiconductor junction; a thickness of the p-type semiconductor material ranges from 1 nm to 2.0 µm, a thickness of the light emitting structure ranges from 1 nm to 1.0 µm, and a thickness of the n-type semiconductor material ranges from 1 nm to 2.5 µm; and the semiconductor structure comprises one of or a combination of more of a single semiconductor junction, a semiconductor pair junction and a semiconductor junction.

4. The electrical contact-free µLED light emitting device based on a wavelength down-conversion according to claim 1, wherein the upper driving electrode is disposed on a surface of the upper transparent substrate, the lower driving electrode is disposed on a surface of the lower transparent substrate, the upper driving electrode and the lower driving electrode are parallelly or perpendicularly disposed along a horizontal direction, and there is a certain gap between the upper driving electrode and the lower driving electrode to form an independent space.

5. The electrical contact-free µLED light emitting device based on a wavelength down-conversion according to claim 4, wherein at least one of the upper driving electrode and the lower driving electrode is a transparent electrode, and a material of the transparent electrode comprises one of or a combination of more of graphene, indium tin oxide, a carbon nano tube, a silver nanowire and a copper nanowire; and a material of the other transparent electrode comprises a laminated structure of one or more of gold, silver, aluminum and copper or an alloy of more than any two of gold, silver, aluminum and copper.

6. The electrical contact-free µLED light emitting device based on a wavelength down-conversion according to claim 1, wherein the wavelength down-conversion light emitting layer irradiated by the first light source emitted by the µLED crystal grain excites the second light source with a longer wavelength, the second light source being any one of a red pixel point light source, a green pixel point light source and a blue pixel point light source; a material of the wavelength down-conversion light emitting layer is a quantum dot material or a fluorescent powder material or a mixed material of both the quantum dot material and the fluorescent powder material; or the wavelength down-conversion light emitting layer is a quantum dot light emitting layer or a fluorescent powder light emitting layer; and a thickness of the wavelength down-conversion light emitting layer ranges from 1 nm to 10 µm.

7. The electrical contact-free µLED light emitting device based on a wavelength down-conversion according to claim 4, wherein the wavelength down-conversion light emitting layers can be disposed on the surfaces of the upper driving electrode and the lower driving electrode or can be disposed on an outer surface of the µLED crystal grain or can be mixed and coated together with the µLED crystal grain, and is disposed in the independent space formed by the upper driving electrode and the lower driving electrode.

8. The electrical contact-free µLED light emitting device based on a wavelength down-conversion according to claim 1, wherein the insulators can be disposed on the surfaces of the upper driving electrode and the lower driving electrode or can be disposed on the surfaces of the wavelength down-conversion light emitting layers or can be disposed between the wavelength down-conversion light emitting layer and the upper driving electrode and between the wavelength down-conversion light emitting layer and the lower driving electrode; a material of the insulators is an organic insulating material, an inorganic insulating material or a combination of the organic insulating material and the inorganic insulating material; and a thickness of the insulating material ranges from 1 nm to 10 µm.

9. The electrical contact-free µLED light emitting device based on a wavelength down-conversion according to claim 1, wherein the control module can provide an alternating voltage with time-varying amplitude and polarity, a waveform of the alternating voltage comprising a sine wave, a triangular wave, a square wave, a pulse or a composite wave of the sine wave, the triangular wave, the square wave and the pulse, and a frequency of the alternating voltage ranging from 1 Hz to 1000 MHz.

10. The electrical contact-free µLED light emitting device based on a wavelength down-conversion according to claim 5, further comprising the optical micro-structure that is composed of a distributed Brag reflecting layer and a convex lens, the optical micro-structure being disposed corresponding to the transparent electrode; the distributed Brag reflecting layer is formed by stacking two thin films with high and low refractive indexes; the first light source emitted by the µLED crystal grain can excite the wavelength down-conversion light emitting layer to emit the rays of the second light source to pass through from the top by controlling the thicknesses of the thin films with high and low refractive indexes of the distributed Brag reflecting layer, and the unabsorbed rays are reflected back to excite the wavelength down-conversion light emitting layer again to enhance the emergent intensity of light, so that the light emitting efficiency of the µLED device is improved; and the convex lens is a transparent convex lens, a length of the convex lens is greater than or equal to a horizontal size of the µLED crystal grain, and a width of the convex lens is greater than or equal to a longitudinal size of the µLED crystal grain.
